# EUROPÄISCHE PATENTSCHRIFT

(11) **EP 0 965 103 B1**
(45) Veröffentlichungstag und Bekanntmachung des Hinweises auf die Patenterteilung: **14.08.2002**
(21) Anmeldenummer: 98909358.8
(22) Anmeldetag: 06.02.1998
(51) Int. Cl.: G06K 19/077

(54) **CHIPKARTENMODUL UND DIESEN UMFASSENDE CHIPKARTE**
CHIP CARD MODULE AND CHIP CARD COMPRISING SAME
MODULE DE CARTE A PUCE ET CARTE A PUCE COMPORTANT CE DERNIER

(30) Priorität: 03.03.1997 DE 19708617
(43) Veröffentlichungstag der Anmeldung: 22.12.1999
(73) Patentinhaber: Infineon Technologies AG, 81669 München (DE)
(72) Erfinder: HOUDEAU, Detlef, D-84085 Langquaid (DE); PÜSCHNER, Frank, D-93309 Kehlheim (DE); STAMPKA, Peter, D-92421 Schwandorf (DE); HUBER, Michael, D-93152 Nittendorf (DE); HEITZER, Josef, D-93090 Bach (DE); MUNDIGL, Josef, D-93182 Duggendorf (DE)
(74) Vertreter: Hermann, Uwe, Dipl.-Ing.
(86) Internationale Anmeldenummer: DE9800349
(87) Internationale Veröffentlichungsnummer: WO9839733

(56) Entgegenhaltungen:
- EP-A- 0 071 311
- EP-A- 0 207 852
- EP-A- 0 323 295
- EP-A- 0 688 050
- WO-A-92/13319

## Beschreibung

Chipkartenmodule bestehen üblicherweise aus einem Träger, auf welchem ein Halbleiterchip aufgeklebt oder auf sonstige Weise befestigt ist. Der Träger kann eine dünne Leiterplatte oder eine Kunststoffolie sein, auf deren vom Chip abgewandter Seite eine elektrisch leitfähige Schicht aus Kupfer oder ähnlichem auflaminiert ist, welche zu einzelnen Kontaktflächen strukturiert ist, die mit einem Kartenlesegerät abgegriffen werden können. Anstelle der laminierten Trägerfolie kann der Halbleiterchip auch auf einen metallischen Anschlußrahmen (Leadframe) - mit oder ohne Zwischenträger - angebracht werden, in welchen die einzelnen Kontaktflächen eingestanzt sind. Die Form und Größe der Kontaktflächen richtet sich in der Regel nach bestimmten Normvorgaben wie beispielsweise dem ISO-Standard 7816. Halbleiterchip und Kontaktflächen sind in herkömmlichen Chipkartenmodulen mit Hilfe von Bonddrähten, die von den Kontaktierungsstellen des Halbleiterchips zu den Anschlußstellen der Kontaktflächen geführt sind, elektrisch kontaktiert. Alternativ kann der Halbleiterchip in Flip-Chip-Technik aufgebracht sein.

Zum Schutz des Chips und der Verbindungen zu den Kontaktflächen wird über dem Chip und den Verbindungsstellen eine Schicht aus Epoxidharz, duroplastischem Kunststoff oder ähnlichem aufgebracht. Der fertige Chipkartenmodul wird schließlich in den Kartenträger einer Chipkarte implantiert.

Derartige Chipkartenmodule sind beispielsweise der DE 44 24 396 C2, DE 195 32 755 C1, DE 26 59 573 C2 und US-A-4,803,542 sowie der EP 0 071 311 A1 zu entnehmen.

Insbesondere weist der aus der DE 195 32 755 C1 bekannte Chipkartenmodul, von dem im Oberbegriff des Anspruchs 1 ausgegangen wird, einen metallischen Anschlußrahmen mit in Flip-Chip-Technik aufgebrachtem Halbleiterchip auf. Der Anschlußrahmen weist eine dreidimensionale, durch Ätzen hergestellte Struktur auf.

Die DE 195 12 191 C1 beschreibt spezielle Werkstoffe zur Herstellung von Anschlußrahmen von Chipkartenmodulen. In der JP-A-6-342794 wird ein Halbleiterpackage beschrieben, bei welchem eine Passivierungsschicht zwischen Chipoberfläche und Gehäuse eine Elektrodenoberfläche teilweise abdeckt.

Die auf oben beschriebene Weise aufgebauten Chipkartenmodule besitzen im allgemeinen eine Bauteilhöhe von mindestens 500 bis 600 µm. Geringere Bauteilhöhen konnten bisher nicht realisiert werden. Zudem kann aufgrund der relativ großen Bauteilhöhe der Chipkartenmodule der Kartenträger im Bereich des Moduls nur sehr dünn sein, um die vorgegebene Gesamtdicke der Chipkarte nicht zu überschreiten. Im Bereich des Chipkartenmoduls treten daher Einfallstellen auf der Kartenoberfläche auf.

**Aufgabe** der Erfindung ist es, einen Chipkartenmodul zu schaffen, der einfach und effektiv herzustellen ist und der eine möglichst geringe Bauteilhöhe aufweist. Der Halbleiterchip sollte dabei möglichst gut gegen mechanische Beschädigung und chemische Einflüsse geschützt sind. Außerdem soll sich durch Verwendung des Chipkartenmoduls eine Chipkarte mit möglichst ebener Oberfläche ohne Aufwölbungen oder Einfallstellen herstellen lassen.

Die Aufgabe wird durch den Chipkartenmodul gemäß Anspruch 1 gelöst. Bevorzugte und zweckmäßige Weiterbildungen ergeben sich aus den Unteransprüchen. In einem weiteren Aspekt betrifft die Erfindung eine Chipkarte gemäß Anspruch 10, welche einen erfindungsgemäßen Chipkartenmodul umfaßt, sowie ein Verfahren gemäß Anspruch 9 zur Herstellung des Chipkartenmoduls.

Die Erfindung zeichnet sich dadurch aus, daß der Halbleiterchip nicht als "nackter" Chip in den Chipkartenmodul eingebaut ist, sondern auf wenigstens einer Seite mit einer elektrisch isolierenden Schutzschicht versehen ist, auf deren vom Halbleiterchip abgewandten Oberfläche Anschlußflächen ausgebildet sind, die mit den Kontaktierungsstellen des Halbleiterchips elektrisch leitend verbunden sind. Diese Schutzschicht sorgt für einen erhöhten Schutz des Iialbleiterchips gegen mechanische Beanspruchung und hält. gleichzeitig Feuchtigkeit und andere schädliche Chemikalien fern. Ein besonders guter Schutz ist gewährleistet, wenn auf Ober- und Unterseite des Halbleiterchips Schutzschichten vorgesehen sind oder der Halbleiterchip allseitig von einem Gehäuse umschlossen ist.

Die beschriebenen Halbleiter-Bauteile mit auf einer Oberfläche angeordneten Anschlußflächen werden üblicherweise als "Die Size-Packages" bezeichnet und sind beispielsweise in der WO 96/02071 beschrieben.

Die elektrische Kontaktierung des Halbleiterchips mit den Kontaktflächen des metallischen Anschlußrahmens erfolgt über die auf einer der Oberflächen des Die Size-Packages liegenden Anschlußflächen. Hierzu wird das Package mit den Anschlußflächen voran auf den Anschlußrahmen aufgesetzt, und die elektrischen Kontakte werden hergestellt.

Dies kann beispielsweise durch Lötverbindungen geschehen. Dann bestehen die Anschlußflächen, die auch als Bondhügel bezeichnet werden, aus einem Lotmaterial wie Weichlot oder Lotpaste oder aus einem lötbeständigen Material. In letzterem Fall wird auf die Anschlußflächen des Halbleiterchip-Bauteils und/oder auf die Kontaktierungsstellen des Anschlußrahmens ein Lotmaterial aufgetragen, und dann werden die Lötverbindungen hergestellt. Bevorzugt werden die Lötverbindungen mit Zinn-Blei-Lot ausgeführt. Aufgrund der hohen Duktilität dieses Materials können die Lötverbindungen hohe mechanische Spannungen absorbieren, ohne daß Materialermüdungen auftreten.

Besonders günstige Ergebnisse werden erzielt, wenn der metallische Anschlußrahmen aus Kupfer oder einer Kupfer-Legierung besteht. Bevorzugte Legierungen sind Kupfer-Zinn-Legierungen wie CuSn₆. Wegen der hohen Duktilität dieser Materialien sind die so hergestellten Chipkartenmodule und die diese enthaltenden Chipkarten sehr wenig anfällig gegen Biegebelastungen. Ihre Zuverlässigkeit ist daher ausgezeichnet.
Die Abgriffseite des Anschlußrahmens kann auf bekannte Weise mit einer oder mehreren Schutzschichten versehen sein.

Die Lötverbindungen zwischen Chip-Anschlußflächen und Anschlußrahmen können auf an sich bekannte Weise hergestellt werden. Ein bevorzugtes Verfahren ist das Heißluftlöten. Die Lötfähigkeit bietet zudem die Gewähr dafür, daß das Gehäuse einen hohen Widerstand gegen Feuchtigkeit aufweist, die Gefahr von Rissen im Package aufgrund eindringender Feuchtigkeit also minimal ist.

Eine alternative Kontaktierungsmethode besteht darin, Anschlußflächen und Anschlußrahmen mit Hilfe eines leitfähigen Klebstoffes zu verbinden. Materialien und Techniken entsprechen den üblicherweise auf dem Gebiet der Halbleitertechnologie verwendeten.

Die Montage der Die Size-Packages kann grundsätzlich auf herkömmliche Weise unter Verwendung üblicher Verfahrensschritte erfolgen. Zweckmäßig erfolgt die Montage auf einem Anschlußrahmenband, aus dem die einzelnen Chipkartenmodule und die Kontaktflächen erst nach Positionierung und Kontaktierung der Die Size-Packages herausgetrennt werden.
Die Implantation der erfindungsgemäßen Chipkartenmodule in eine Chipkarte erfolgt mittels gängiger Verfahren.

Neben den bereits erwähnten Vorteilen der erhöhten Stabilität und Zuverlässigkeit gegen mechanische und chemische Belastungen weisen die erfindungsgemäßen Chipkartenmodule einige weitere Vorteile auf. Zum einen sind sie mit geringem Materialaufwand einfach, schnell und kostengünstig herstellbar. Dadurch daß keine Abdeckung des montierten Halbleiterchips mit Epoxidharz oder ähnlichem erforderlich ist, kann gegenüber herkömmlichen Fertigungsverfahren ein Arbeitsschritt eingespart werden. Zudem unterliegt die Gehäusegröße des Die Size-Package nur äußerst geringen Schwankungen, so daß Chipkartenmodule mit reproduzierbaren Konturen herstellbar sind. Weiterhin ist die Bauhöhe der erfindungsgemäßen Chipkartenmodule geringer als diejenige der auf übliche Weise hergestellten Module. Dies wirkt sich auf die Chipkartenqualität aus. Aufgrund der geringen Bauteil-Gesamthöhe des Chipkartenmoduls kann der Kartenträger, dort wo der Chipkartenmodul implantiert werden soll, eine höhere Wanddicke aufweisen als bei herkömmlichen Chipkartenmodulen, so daß die Chipkarte eine ebene Oberfläche ohne Einfallstellen auf der Kartenoberfläche besitzt.

Die Erfindung soll nachfolgend unter Bezugnahme auf eine Zeichnung näher erläutert werden. Darin zeigen
- Fig. 1: schematisch einen erfindungsgemäßen Chipkartenmodul in Draufsicht;
- Fig. 2: schematisch den Chipkartenmodul gemäß Fig. 1 im Querschnitt und
- Fig. 3: schematisch eine Chipkarte, welche den Chipkartenmodul gemäß Fig. 1 und 2 enthält.

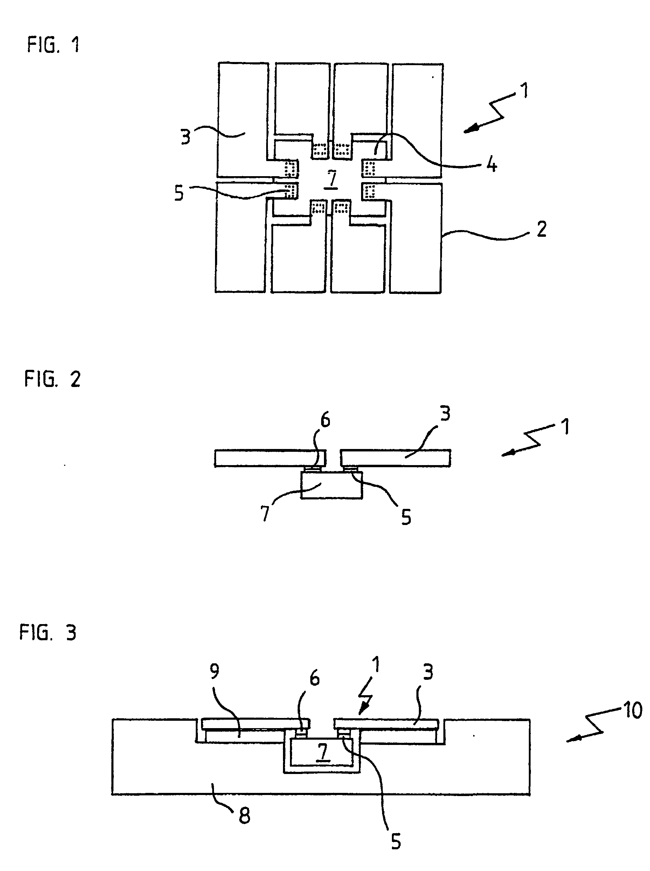

Der in Fig. 1 dargestellte Chipkartenmodul 1 umfaßt einen Anschlußrahmen 2, aus dem Kontaktflächen 3 herausgestanzt sind. Die einzelnen Kontaktflächen 3 sind jeweils mit einer Anschlußfläche 5, deren Lage durch die gepunkteten Bereiche verdeutlicht ist, elektrisch leitend verbunden. Die Anschlußflächen 5 sind auf einer Oberfläche 4 eines Die Size-Packages 7 angeordnet. Das Package dient im fertigen Chipkartenmodul als Bindeglied, welches die bei der Vereinzelung der Chipkartenmodule aus dem Anschlußrahmen herausgestanzten Kontaktflächen 3 verankert.

Fig. 2 zeigt den Chipkartenmodul gemäß Fig. 1 im Querschnitt im Bereich von zwei Anschlußflächen 5. Diese sind mit den zugehörigen Kontaktflächen 3 durch eine Lotverbindung 6 elektrisch leitend verbunden.

In Fig. 3 ist im Querschnitt eine Chipkarte 10 dargestellt, in die der in Fig. 1 und 2 gezeigte Chipkartenmodul implantiert ist. Die Implantation erfolgt auf herkömmliche Weise, indem der Chipkartenmodul 1 in eine Ausnehmung im Kartenkörper 8 mit Klebstoff 9 eingeklebt wird.

## Patentansprüche

1. Chipkartenmodul (1), welcher einen Halbleiterchip umfaßt, der elektrisch leitend mit einem metallischen Anschlußrahmen (2) kontaktiert ist, in dem Kontaktflächen (3) ausgebildet sind,
**dadurch gekennzeichnet,**
**daß** der Halbleiterchip auf wenigstens einer Seite mit einer elektrisch isolierenden Schutzschicht versehen ist, auf deren vom Halbleiterchip abgewandter Oberfläche (4) Anschlußflächen (5) ausgebildet sind, die mit den Kontaktierungsstellen des Halbleiterchips elektrisch leitend verbunden sind, und
**daß** der Halbleiterchip mit den Anschlußflächen (5) voran auf den Anschlußrahmen (2) aufgesetzt und über die Anschlußflächen (5) mit den Kontaktflächen (3) elektrisch leitend kontaktiert ist.

2. Chipkartenmodul gemäß Anspruch 1,
**dadurch gekennzeichnet,**
**daß** die Anschlußflächen (5) an die Kontaktflächen (3) gelötet sind.

3. Chipkartenmodul gemäß Anspruch 2,
**dadurch gekennzeichnet,**
**daß** die Anschlußflächen (5) durch Heißluftlöten an den Kontaktflächen (3) befestigt sind.

4. Chipkartenmodul gemäß Anspruch 3,
**dadurch gekennzeichnet,**
**daß** die Lötverbindung (6) aus Zinn-Blei-Lot besteht.

5. Chipkartenmodul gemäß Anspruch 1,
**dadurch gekennzeichnet,**
**daß** die Anschlußflächen (5) mit einem elektrisch leitfähigen Klebstoff an die Kontaktflächen (3) geklebt sind.

6. Chipkartenmodul gemäß einem der Ansprüche 1 bis 5,
**dadurch gekennzeichnet**
**daß** der Anschlußrahmen (2) aus Kupfer oder einer Kupfer-Legierung besteht.

7. Chipkartenmodul gemäß Anspruch 6,
**dadurch gekennzeichnet,**
**daß** der Anschlußrahmen (2) aus einer Kupfer-Zinn-Legierung und insbesondere aus CuSn₆ besteht.

8. Chipkartenmodul gemäß einem der Ansprüche 1 bis 7,
**dadurch gekennzeichnet,**
**daß** der Halbleiterchip auf Ober- und Unterseite mit elektrisch isolierenden Schutzschichten versehen ist.

9. Chipkartenmodul gemäß einem der Ansprüche 1 bis 7,
**dadurch gekennzeichnet,**
**daß** der Halbleiterchip allseitig von einem elektrisch isolierenden Gehäuse (7) umschlossen ist.

10. Chipkarte (10),
**dadurch gekennzeichnet,**
**daß** sie einen Chipkartenmodul (1) gemäß einem der Ansprüche 1 bis 9 umfaßt.

## Claims

1. Smart card module (1) comprising a semiconductor chip, which is electrically conductively connected to a metallic lead frame (2) in which contact areas (3) are formed,
**characterized**
**in that** the semiconductor chip is provided with an electrically insulating protective layer on at least one side, connection areas (5) which are electrically conductively connected to the contact-making points of the semiconductor chip being formed on that surface (4) of the said protective layer which is remote from the semiconductor chip, and
**in that** the semiconductor chip is placed with the connection areas (5) at the front onto the lead frame (2) and is electrically conductively connected to the contact areas (3) via the connection areas (5).

2. Smart card module according to Claim 1,
**characterized**
**in that** the connection areas (5) are soldered onto the contact areas (3).

3. Smart card module according to Claim 2,
**characterized**
**in that** the connection areas (5) are fastened by means of hot-air soldering to the contact areas (3).

4. Smart card module according to Claim 3,
**characterized**
**in that** the soldered joint (6) is composed of tin-lead solder.

5. Smart card module according to Claim 1,
**characterized**
**in that** the connection areas (5) are bonded to the contact areas (3) by means of an electrically conductive adhesive.

6. Smart card module according to one of Claims 1 to 5,
**characterized**
**in that** the lead frame (2) is composed of copper or of a copper alloy.

7. Smart card module according to Claim 6,
**characterized**
**in that** the lead frame (2) is composed of a copper-tin alloy, in particular of CuSn₆.

8. Smart card module according to one of Claims 1 to 7,
**characterized**
**in that** the semiconductor chip is provided with electrically insulating protective layers on the top side and underside.

9. Smart card module according to one of Claims 1 to 7,
**characterized**
**in that** the semiconductor chip is enclosed by an electrically insulating housing (7) on all sides.

10. Smart card (10),
**characterized**
**in that** it comprises a smart card module (1) according to one of Claims 1 to 9.

## Revendications

1. Module (1) de carte à puce qui comprend une puce à semi-conducteur qui est en contact d'une manière conductrice de l'électricité avec un cadre (2) métallique de connexion, dans lequel sont constituées des surfaces (3) de contact,
**caractérisé**
**en ce que** la puce à semi-conducteur est munie au moins d'un côté d'une couche de protection isolante du point de vue électrique sur la face (4) de laquelle, qui est éloignée de la puce à semi-conducteur, sont constituées des surfaces (5) de connexion qui sont reliées d'une manière conductrice de l'électricité aux points d'établissement du contact de la puce à semi-conducteur et
**en ce que** la puce à semi-conducteur ayant les surfaces (5) de connexion est posée à l'avance sur le cadre (2) de connexion et est mise en contact d'une manière conductrice de l'électricité avec les surfaces (3) de contact par les surfaces (5) de connexion.

2. Module de carte à puce suivant la revendication 1, **caractérisé en ce que** les surfaces (5) de connexion sont brasées aux surfaces (3) de contact.

3. Module de carte à puce suivant la revendication 2, **caractérisé en ce que** les surfaces (5) de connexion sont fixées par brasage à l'air chaud aux surfaces (3) de contact.

4. Module de carte à puce suivant la revendication 3, **caractérisé en ce que** le joint (6) brasé est en brasure à l'étain et au plomb.

5. Module de carte à puce suivant la revendication 1, **caractérisé en ce que** les surfaces (5) de connexion sont collées aux surfaces (3) de contact par une colle conductrice de l'électricité.

6. Module de carte à puce suivant l'une des revendications 1 à 5, **caractérisé en ce que** le cadre (2) de connexion est en cuivre ou en un alliage de cuivre.

7. Module de carte à puce suivant la revendication 6, **caractérisé en ce que** le cadre (2) de connexion est en alliage de cuivre et d'étain et notamment en CuSn₆.

8. Module de carte à puce suivant l'une des revendications 1 à 7, **caractérisé en ce que** la puce à semi-conducteur est munie de couches isolantes du point de vue électrique sur ses faces supérieure et inférieure.

9. Module de carte à puce suivant l'une des revendications 1 à 7, **caractérisé en ce que** la puce à semi-conducteur est entourée de tous côtés d'un boîtier (7) isolant du point de vue électrique.

10. Carte (10) à puce,
**caractérisée**
**en ce qu'**elle comprend un module (1) de carte à puce suivant l'une des revendications 1 à 9.
